# EUROPEAN PATENT APPLICATION

(11) **EP 1 460 763 A1**
(43) Date of publication of application: **22.09.2004**
(21) Application number: 02790856.5
(22) Date of filing: 25.12.2002
(51) Int. Cl.: H03M 1/56, H03M 1/14

(54) **ANALOG-DIGITAL CONVERSION APPARATUS**

(30) Priority: 28.12.2001 JP 2001400672
(71) Applicant: Neuro Solution Corp., Tokyo 158-0091 (JP)
(72) Inventor: KOYANAGI, Yukio, Saitama-shi, Saitama 336-0932 (JP)
(74) Representative: VOSSIUS & PARTNER
(86) International application number: PCT/JP2002/013481
(87) International publication number: WO 2003/058821

(57) **Abstract**

The conversion processors 1₋₁-1₋₄ based on a 4-bit unit are connected in a multistage manner, the number of clocks according to the analog input voltage is counted at each conversion processor 1₋₁-1₋₄, and a 4-bit digital signal is obtained. And the surplus voltage in proportion to the length of incomplete clock that is not counted at the conversion processor at the preceding stage is obtained and is transmitted to the conversion processor at the subsequent stage. The 4-bit digital signal obtained at conversion processors 1₋₁-1₋₄ is outputted as a 16-bit digital signal via the shift registers 3₋₁-3₋₄. Due to this, achieving 4-bit resolution may be acceptable at the individual conversion processors 1₋₁-1₋₄, and it is not necessary to cause the clock frequency of the counter 2₋₁-2₋₄ to be high. Therefore, while achieving high resolution, the accuracy of A/D conversion can be improved.

## Description

### [Field of the Invention]

The present invention relates to an analog-digital conversion apparatus that converts analog signals into digital signals.

### [Background of the Invention]

In recent years, due to the advancement of LSI technology, a method to treat analog signals in a digital manner in various fields such as communication, measurement, sound and image signal processing, medicine, and seismology has been popularized. In order to carry out digital processing of analog signals, an A/D conversion apparatus that converts an analog quantity into a digital quantity is essential.

There are a wide variety of types of A/D conversion apparatuses. Apparatuses whose structures or principles are different are used according to the purpose of use. A/D conversion apparatuses are roughly divided into those involving an integral method and those involving a comparison method. Furthermore, the integral method is classified into a dual slope type and a charge parallel type. And the comparison method is categorized into a feedback comparison type (serial comparison type) and non-feedback comparison type (parallel type or flash, type). The speed of the integral method that creates accuracy using a time-axis is slow, although it is suitable for high resolution. Simultaneously, the speed of the comparison method that creates accuracy by elements is high, although it is suitable for low resolution (8-12 bits).

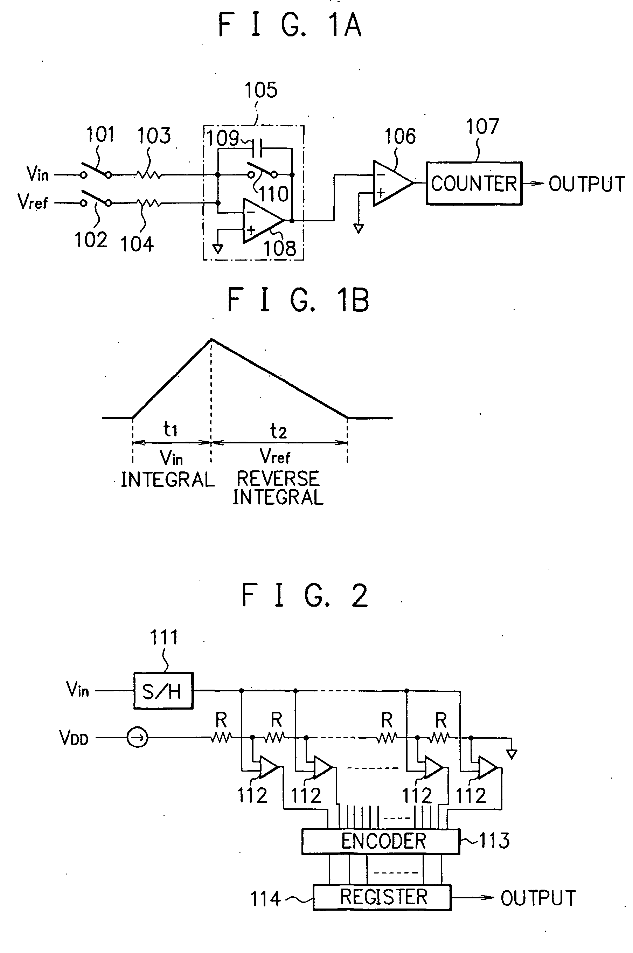

FiG.1A and 1 B show the structure and operations of the A/D conversion apparatus based on the integral method. A block diagram shown in FIG. 1A, 105 denotes an integrator that is equipped with an operational amplifier 108, condenser 109, and switch 110. A noninverting input terminal of the operational amplifier 108 is connected to the earth. The condenser 109 and switch 110 are connected between the inverting input terminal and the output terminal in a parallel manner.

The voltage Vᵢₙ of the input analog signal is inputted into the input terminal of the integrator 105 (inverting input terminal of the operational amplifier 108) via the switch 101 and resistance 103 that are series-connected. And the reference voltage V_{ref} is inputted into the input terminal of the integrator 105 (inverting input terminal of the operational amplifier 108) via the switch 102 and the resistance 104 that are series-connected. Additionally, the inverting input terminal of the comparator 106 is connected at the output terminal of the integrator 105. The noninverting input terminal of the comparator 106 is connected to the earth, and the output terminal is connected to the counter 107.

Regarding the reset period, the switch 110 of the integrator 105 should be kept on, the charge of the condenser 109 should be discharged, and the output of the integrator 105 should be set as zero. The switches 101 and 102 are kept off in the initial condition, and the switch 101 is turned on only at a given time ti when conversion operation of A/D starts. While the conversion operation of A/D is executed, the switch 110 is kept off. Due to this, the amount of time t₁ of the input analog voltage Vᵢₙ is integrated by the integrator 105. The outcome of this is accumulated in the condenser 109.

Next, the switch 101 is set to an off state, and the switch 102 is set to an on state. At this time, the integrator 105 inputs the integrated outcome of the input analog voltage Vᵢₙ that has been accumulated in the condenser 109 and the reverse polarity reference voltage V_{ref} in the operational amplifier 108. Until the comparator 106 detects that the output of the integrator 105 has become zero, reverse integration is executed by the reference voltage V_{ref}. The time t₂ regarding which the reverse integration is executed by the reference voltage V_{ref} is measured by the counter 107. Due to this, the analog input voltage Vᵢₙ can be converted into digital data.

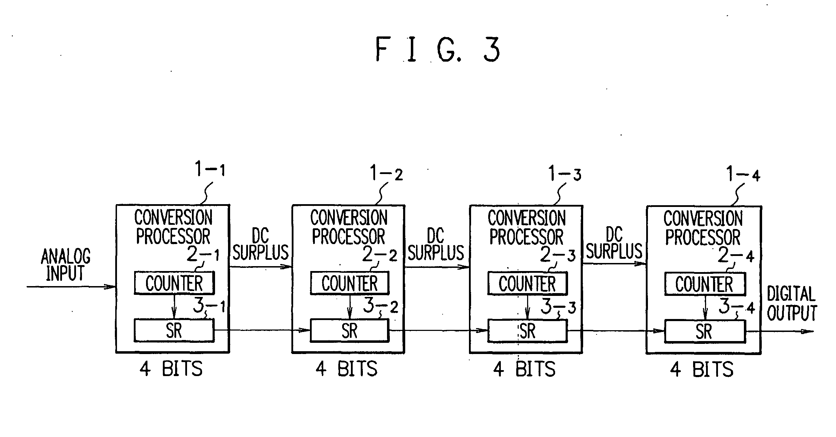

FIG. 2 shows the structure of the A/D conversion apparatus in a comparison method. In FIG. 2, 111 denotes the sample and hold circuit that keeps the voltage Vᵢₙ of the input analog signal, and 112 denotes the plurality of comparators. The output of the sample and hold circuit 111 is connected to other input terminals of all comparators 112. The output taps of a plurality of resistances R which provide divided voltage of the voltage VDD in an equal manner is connected to another input terminal.

The comparators 112 compare the analog input voltage Vᵢₙ that is outputted from the sample and hold circuit 111 with the divided voltage of the voltage VDD that has been equally divided by the plurality of resistance R. According to a result of such comparison, a value of either 0 or 1 is outputted into the encoder 113. At this time, the data inputted into the encoder 113 is data where the value of either 0 or 1 on both sides in the boundary of any of the comparators 112 is sequel according to the size of the analog input voltage Vᵢₙ. The encoder 113 encodes the output data of the comparators 112 as the predominated bit digital data, and outputs such data via the resistor 114.

However, regarding the conventional integral type A/D conversion apparatus shown above, there has been a problem in that a speed of A/D conversion is slow as stated above. Conventionally, the A/D conversion apparatus based on a cascade integral method is also proposed in order to raise the conversion speed. Basic operations in this cascade integral method are performed by dividing the integral of the reference voltage V_{ref} into 2 stages. That is to say, the converted bits are divided into high-order bits and low-order bits. The integral of a high-order bit is roughly and rapidly performed so as to shorten the time during the fist half of the process. And the integral of the low-order bit is moderately performed so as to create accuracy during the second half of the process. Through this process, while maintaining accuracy, the shortening of the time is attempted overall.

However, in the conventional cascade integral method, it has been required to prepare 2 types of reference voltage V_{ref}, which causes a problem in terms of a complication of the circuit structure. Additionally, regarding the low-order bit during the second half of the process, it is necessary to moderately perform integration, which causes a problem in that an increase of the conversion speed cannot be sufficiently made.

Also, so as to improve the resolution of the A/D conversion, it is necessary to raise the clock frequency of the counter. However, to cause the clock frequency to be unlimitedly high cannot be performed because of various restrictions, which causes a problem in that the resolution cannot be easily improved. For example, 16-bit resolution is required for audio sound. However, when A/D conversion is executed for audio signal whose sampling frequency is 44.1 KHz, the clock frequency required for 16-bit accuracy is about 3 GHz. However, it is not easy to realize such an extremely high clock frequency. Also, since the waveform of a clock pulse cannot be maintained, there is a problem in that the conversion accuracy cannot be improved.

On the contrary, the comparison A/D conversion apparatus can cause the speed of the A/D conversion to be fast. However, according to this type, the comparators that compare the input analog voltage with reference voltage and the voltage-divided resistances, etc. of the number equitant to conversion resolution are required (for example 65,536 units for a 16-bit A/C conversion apparatus are required). Also, in proportion to the number of comparators, the size of the encoder circuit becomes enormous, which is a major factor of large chip size and rising costs.

The purpose of the present invention is to resolve such problems. That is to say, without making the circuit size large, both of improvement of speed and of resolution for A/D conversion can be achieved.

### [Summary of the Invention]

An analog-digital conversion apparatus that converts an analog signal into a digital signal based on the predominated bit unit comprises a lamp voltage generation circuit that generates lamp voltage changing at a certain rate from the predominated reference voltage; a counter circuit that counts the number of complete clocks included during a period until the lamp voltage and analog input voltage are matched, and that outputs a digital signal of the predominated number of bits in proportion to the analog input voltage, and a surplus detection circuit that detects an incomplete clock other than the complete clock included during a period until the lamp voltage and the analog input voltage are matched; and that outputs voltage in proportion to the time of the incomplete clock as the surplus voltage. The digital signal of the predominated number of bits is outputted by initially counting the number of complete clocks included during a period until the lamp voltage and the analog input voltage are matched, and the digital signal of the predominated number of bits is outputted by counting the number of complete clocks during a period until the lamp voltage and the surplus voltage are matched thereafter.

In another aspect of the present invention, the surplus detection circuit outputs surplus voltage that is multiplied several times according to the resolution.

For example, based on a performance where the voltage value resulting when the voltage in proportion to the time from when the lamp voltage and the analog input voltage are matched until when the next clock starts multiplied several times according to the resolution is deducted from the maximum value of the lamp voltage, the surplus detection circuit obtains the surplus voltage that is multiplied several times according to the resolution.

In another aspect of the present invention, conversion processors that convert an analog signal into a digital signal based on the predominated bit unit are connected at a plurality of stages, each of such conversion processors has the lamp voltage generation circuit, the counter circuit, and the surplus detection circuit, the surplus voltage outputted from a conversion processor at the preceding stage is inputted into a conversion processor at the later stage as the analog input voltage, and the conversion processors at the plurality of stages operate in parallel.

In another aspect of the present invention, conversion processors that convert an analog signal into a digital signal on the predominated bit unit are connected at a plurality of stages, the number of clocks according to the analog input voltage is counted at each conversion processor, the digital signal of the predominated bits is obtained, the surplus voltage in proportion to the length of incomplete clock that is not counted at each conversion processor is obtained and transmitted into a conversion processor at the subsequent stage, the conversion processor at the subsequent stage processes the surplus voltage as the analog input voltage, and the digital signal of the predominated bits obtained at each conversion processor is outputted as a digital signal of the desirable resolution as a whole.

### [Brief Description of the Drawings]

FIG. 1A and 1 B are diagrams showing the structure and operations of a conventional integral A/D conversion apparatus.
FIG. 2 is a diagram showing the structure of a conventional comparison A/D conversion apparatus.
FIG. 3 is a schematic diagram showing an A/D conversion apparatus of the embodiment.
FIG. 4 is a circuit diagram showing the analog processor with which each conversion processor is equipped.
FIG. 5 is a wave form chart explaining the operations of the analog processor shown in FIG. 4.
FIG. 6 is an image diagram showing the unified assembly of the structure of the digital processor with which each conversion processor is equipped.
FIG. 7 is a wave form chart explaining the operations of the digital processor shown in FIG. 6.
FIG. 8 is a circuit diagram showing the combination of the analog processor and digital processor regarding the internal structure of the conversion processor at the first stage.
FIG. 9 is a circuit diagram showing the combination of the analog processor and digital processor regarding the internal structure of the conversion processor at the second stage.
FIG. 10 is a circuit diagram showing the combination of the analog processor and digital processor regarding the internal structure of the conversion processor at the third stage.
FIG. 11 is a circuit diagram showing the combination of the analog processor and digital processor regarding the internal structure of the conversion processor at the fourth stage.

### [Detailed Description of the Preferred Embodiments]

One embodiment of the present invention is hereinafter explained with reference to the drawings.

FIG. 3 is a diagram showing the schematic structure of the A/D conversion apparatus of the embodiment. Here, explanations are made by taking the A/D conversion apparatus that has a 16-bit conversion resolution as an example. As shown in FIG. 3, the A/D conversion apparatus of the embodiment is structured to have a plurality of conversion processors 1₋₁ - 1₋₄ connected in a multistage manner, which perform A/D conversion based on 4-bit units.

The conversion processors 1₋₁ - 1₋₄ are based on the structure of the integral A/D conversion. Such processors realize a multistage and a large resolution as a whole through minimization of the conversion bit numbers and devising of the surplus computation function described below. The conversion processor 1₋₁ at the first stage is the input processor of analog signals as a target of A/D conversion. And the conversion processors 1₋₂ -1₋₄ are the processor of the surplus signals transmitted from the preceding stage.

The conversion processors 1₋₁ - 1₋₄ are comprised of the analog processor and the 4-layer digital processor that operates time-sharing. The analog processor includes the circuit that detects a matched point of the lamp voltage that rises at a certain rate from the predominated reference voltage V_{ref1} to the voltage V_{ref2} and the analog input voltage to which sample and hold is executed. The analog processor with which the conversion processors 1₋₁ -1₋₃ are equipped from the first stage to the third stage include a circuit that detects the aforementioned surplus signals and outputs such signals to the subsequent stage.

Additionally, each layer of the digital processor has counters 2₋₁-2₋₄ and shift registers 3₋₁-3₋₄. The counters 2₋₁-2₋₄ count the clock number included during a period when the aforementioned lamp voltage and the analog input voltage are matched, and output the 4-bit digital signal in proportion to the analog input voltage. The shift registers 3₋₁-3₋₄ keep the 4-bit digital signals outputted from each counter 2₋₁-2₋₄, gather such signals together through the shift operation, and output such signals as 16-bit digital signals. Through such parallel-serial conversion by the digital processor, the output result of the conversion processors 1₋₁ - 1₋₄ is outputted as high-speed data.

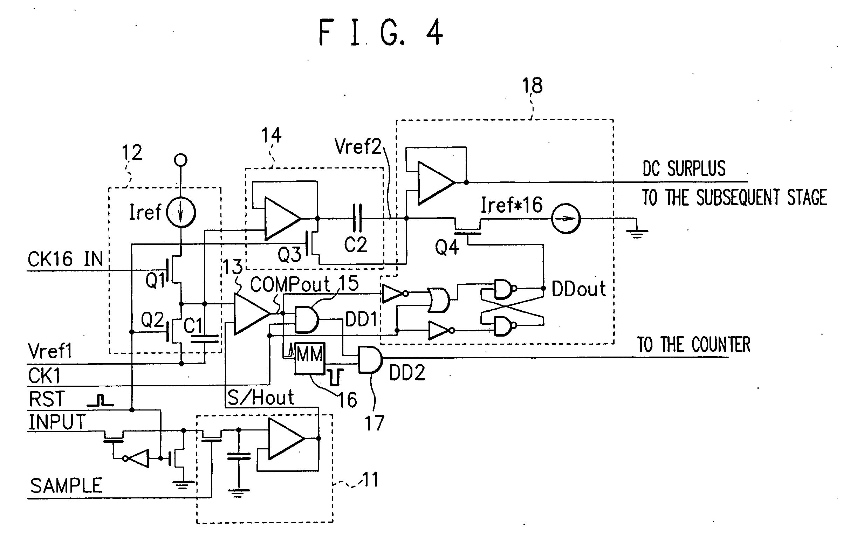

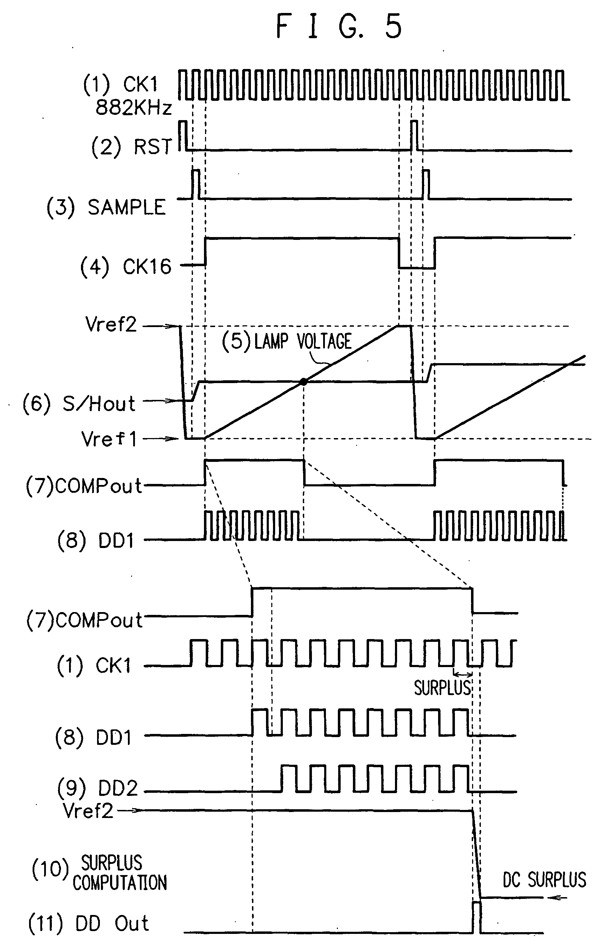

FIG. 4 is a circuit diagram showing the structure of the analog processor with which the conversion processors 1₋₁ - 1₋₄ are equipped. Also, FIG. 5 is a wave form chart explaining the operations of the analog processor shown in FIG. 4. Hereinafter, explanations are made with reference to such FIG. 4 and FIG. 5.

In FIG. 4, the sample and hold is executed regarding analog input voltage INPUT (the voltage of the analog signal as a target of A/D conversion regarding the conversion processor 1₋₁ at the first stage, and the voltage of the surplus signals transmitted from the preceding stage regarding the conversion processor 1₋₂-1₋₄ after the second stage) by the sample and hold circuit 11. After this process, such analog input voltage INPUT is inputted to one of the input terminals of the comparator 13 ((3), (6) in FIG. 5). The lamp voltage generated from the lamp generator 12 is inputted into the other input terminal of the comparator 13.

The lamp generator 12 is structured to be equipped with the constant current source I_{ref} that outputs a certain current value I_{ref}, 2 MOS switches Q1 and Q2 that are connected in a serial manner between such constant current source I_{ref} and the reference voltage V_{ref1}, and the condenser C1 that is connected between the output terminal of the lamp generator 12 and the reference voltage V_{ref1}. The clock CK 16 ((4) of FIG. 5) that has a pulse width equivalent to 16 clock periods (equivalent to 4 bits) of the main clock CK1 ((1) of FIG. 5) is inputted to the gate of the other MOS switch Q1. Additionally, the reset pulse RST ((2) of FIG. 5) is inputted to the gate of another MOS switch Q2.

The operations of the lamp generator 12 are as follows. First of all, the MOS switch Q2 is set to an on state through applying the reset pulse RST. And the condenser C1 is reset to the reference voltage V_{ref1}. Such reference voltage V_{ref1} is smaller than the minimum value of the input voltage of the analog signal as a target of A/D conversion by a value equivalent to the predominated margin. After this, the MOS switch Q1 is set to an on state through applying the clock CK 16. The condenser C1 is charged during the pulse period. As a result, the lamp voltage ((5) of FIG. 5) that gradually increases at a certain rate from the reference voltage V_{ref1} to the voltage V_{ref2} can be obtained.

The reference voltage V_{ref1} is internally generated. On the contrary, the maximum value V_{ref2} of the lamp voltage is determined in one sense through the reference voltage Vref1, the constant current source I_{ref}, and the capacitance of the condenser C1. The maximum value V_{ref2} of the lamp voltage is given to the sample and hold circuit 14, and kept in the condenser C2 until application of the subsequent reset pulse RST is made to the MOS switch Q3 inside the circuit. And such voltage V_{ref2} is used as the reference potential upon the surplus computation described below.

The comparator 13 compares the analog input voltage S/Hₒᵤₜ ((6) of FIG. 5) that is inputted from the sample and hold circuit 11 and the lamp voltage that is inputted from the lamp generator 12. And the comparator 13 outputs a pulse according to such comparison result. That is to say, the pulse COMPₒᵤₜ ((7) of FIG. 5) value becomes 1 during the period until the lamp voltage, which is gradually becoming larger from the reference voltage V_{ref1}, is matched with the analog input voltage S/Hₒᵤₜ. And such pulse COMPₒᵤₜ value becomes 0 after the lamp voltage exceeds the analog input voltage S/Hout. Through this, the output signal COMPₒᵤₜ of the comparator 13 has a pulse width in proportion to the size of the analog input voltage S/Hout.

The output signal COMPₒᵤₜ of the comparator 13 is inputted into the other input terminal of the AND gate 15 and the negative output mono stable multi-vibrator 16. The main clock CK1 is inputted into another input terminal of AND gate 15. According to this, the output signal DD1 of AND gate 15 is shown as in FIG. 5 (8). The signal DD1 indicates the number of main clock CK1 included during the high period of the output signal COMPₒᵤₜ of the comparator 13 (a period until the lamp voltage is matched with the analog input voltage S/Hₒᵤₜ). Thus, when the number of such clock CK1 is counted, it is possible to convert the analog input voltage S/Hₒᵤₜ into a 4-bit digital signal.

However, as shown in FIG. 5, during the high period of the output signal COMPₒᵤₜ, an incomplete surplus portion that does not reach 1 clock width of the main clock CK1 (hereinafter referred to as the "incomplete clock") is included. When such incomplete clock is also counted, the value of the digital signal becomes larger by a value of 1. Thus, the output signal DD1 of AND gate 15 cannot be outputted into the counter as it is. Thus, the signal DD2 ((9) of FIG. 5)
where the value 1 of the number of the main clock CK1, which is included during the high period of signal COMPₒᵤₜ, is reduced, is generated, through using the negative output mono stable multi-vibrator 16. This signal DD2 is outputted into the counter.

That is to say, the negative output mono stable multi-vibrator 16 synchronizes a rise of the signal COMPₒᵤₜ (this synchronizes a rise of the main clock CK1), whose output becomes low. And a negative single pulse where such low period is set up as being slightly longer than 1/2 clock period of the main clock CK1 is outputted. Such output signal of the negative output mono stable multi-vibrator 16 and the output signal DD1 of the AND gate 15 are inputted into AND gate 17. Such AND gate 17 performs the AND operation with the two input signals. Through this process, the output signal DD2 ((9) of FIG. 5) to the counter is generated.

Simultaneously, regarding the incomplete clock, the surplus voltage in proportion to the time of such incomplete clock is generated by the surplus detection circuit 18, which is outputted to the conversion processor at the subsequent stage. The conversion processor at the subsequent stage inputs the surplus voltage transmitted from the preceding stage as the analog input voltage INPUT. Through performance of the same conversion operations as above, such surplus voltage is converted into a 4-bit digital signal which corresponds with the low order from the preceding stage.

A logic circuit that is composed of an inverter as a delay circuit, OR gate, and RS flip-flop is established at the input stage of the surplus detection circuit 18. Based on the output signal COMPₒᵤₜ of the comparator 13 and the main clock CK1, the signal DDₒᵤₜ shown in FIG. 5 (11) is generated by the logic circuit. Such signal DDₒᵤₜ is the pulse signal that becomes 1 based on the falling edge of the output signal COMPₒᵤₜ of the comparator 13 (the time when the analog input voltage S/Hout and the lamp voltage are matched), and that becomes 0 based on the rising edge of the main clock CK1 thereafter. The pulse signal DDₒᵤₜ is inputted in the gate of MOS switch Q4.

The source and drain of the MOS switch Q4 are connected to the condenser C2 and the constant current source I_{ref}*16. The constant current source I_{ref}*16 outputs 16 times more current than that of the constant current source I_{ref} of the lamp generator 12. One end of the constant current source I_{ref}*16 is grounded. As stated above, the maximum value V_{ref2} of the lamp voltage is accumulated in the condenser C2. Due to this, when the MOS switch Q4 is set to an on state during the high period of the pulse signal DDₒᵤₜ, the voltage drops with the maximum value V_{ref2} as the starting point ((10) of FIG. 5) at the slope to an extent 16 times greater than that of the lamp voltage shown in FIG. 5 (5).

The incomplete clock is a period resulting when a period of the pulse signal DDₒᵤₜ shown in FIG. 5 (11) is deducted from 1 clock period of the main clock CK1. Thus, the surplus voltage in proportion to the time of incomplete clock means the voltage in proportion to the difference between such 1 clock of the main clock CK1 and the pulse signal DDₒᵤₜ. Therefore, voltage equivalent to voltage 16 times greater than that of the pulse signal DDₒᵤₜ is deducted from the voltage V_{ref2} equivalent to 16 clocks of the main clock CK1. Through performing the above operation, the voltage resulting when the original surplus voltage is multiplied by 16 is obtained as the DC surplus. Such computation is based on the main clock CK1 except for the accuracy of the constant current source I_{ref}*16 and the condenser C2. Thus, highly accurate results can be obtained.

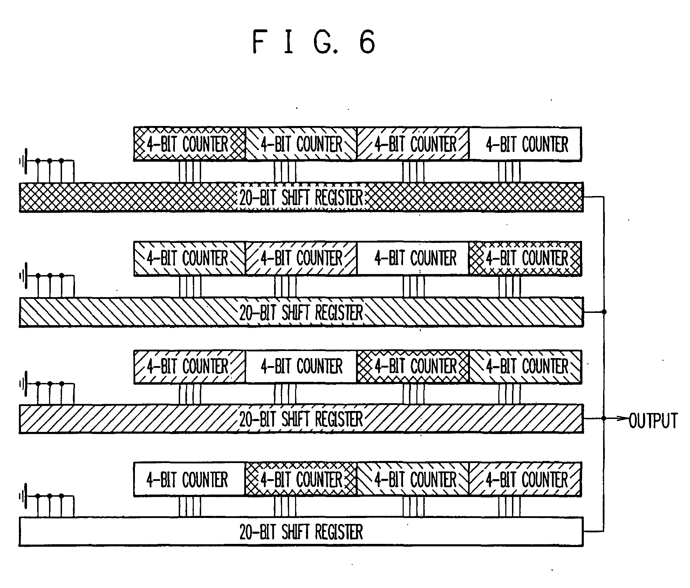

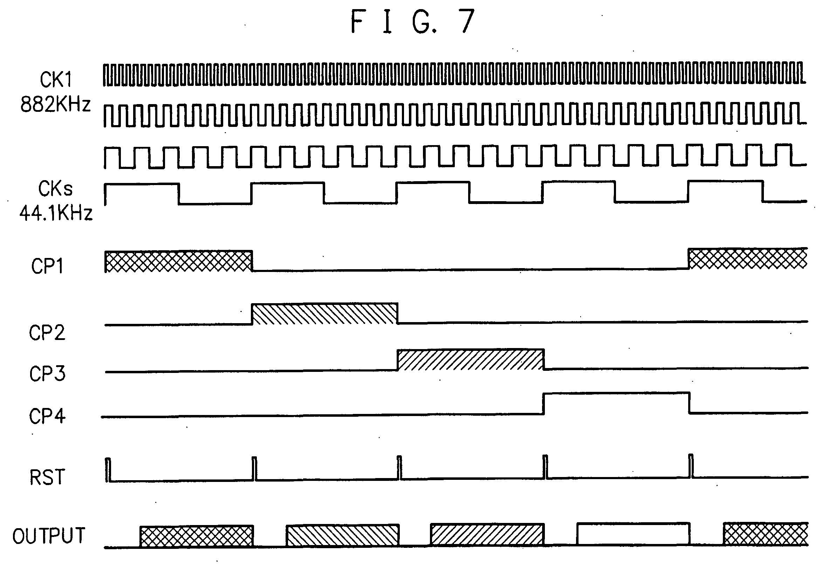

FIG. 6 is an image diagram showing a unified assembly of the structure of the digital processor with which the conversion processors 1₋₁-1₋₄ are equipped. Additionally, FIG. 7 is a wave form chart explaining the operations of the digital processor shown in FIG. 6. In FIG. 6, lining up of 4 4-bit counters in a transverse direction of the Figure indicates that each of such counters is installed each inside the conversion processors 1₋₁-1₋₄. Also, lining up of 4 4-bit counters in a longitudinal direction of the Figure shows that each of such conversion processors 1₋₁-1₋₄ is structured based on 4 layers of time-sharing operations. For example, 4 4-bit counters in the longitudinal directions on the far left side are the 4-layer counters with which the conversion processor 1₋₁ is equipped.

The 20-bit shift register shows the unified assembly of the shift registers with which the digital processors of conversion processors 1₋₁-1₋₄ are equipped (the value of 4 bits at the left edge is fixed as 0). The lining up of such 4 20-bit shift registers in a longitudinal directions of the Figure indicates that each of the conversion processors 1₋₁-1₋₄ is structured based on 4 layers of the time-sharing operations.

As shown in FIG. 7, the 4-layer 4-bit counters (16 counters in total) and 4-layer 20-bit shift registers, with which digital processors of 4 conversion processors 1₋₁-1₋₄ are equipped, operate during the high period of the control pulses CP1-CP4. Such control pulses CP1-CP4 have pulse width equivalent to 1 clock period of the sample clock CKs of 44.1 KHz. In FIG. 6 and FIG. 7, the operation timing of each counter and each shift register is shown by the classifying the type of hatching.

For example, during the high period of the control pulse CP1, the 4-bit counter in the first layer of the conversion processor 1₋₁ at the first stage, the 4-bit counter in the fourth layer of the conversion processor 1₋₂ at the second stage, the 4-bit counter in the third layer of the conversion processor 1₋₃ at the third stage, and the 4-bit counter in the second layer of the conversion processor 1₋₄ at the fourth stage operate, and the 16-bit digital signal followed by four 0 for 4 bits is outputted from the 20-bit shift register in the first layer. As such, through the parallel-serial conversion operation of the 4-layer digital processor with which four conversion processors 1₋₁-1₋₄ are equipped, the improvement of A/D conversion speed is attempted.

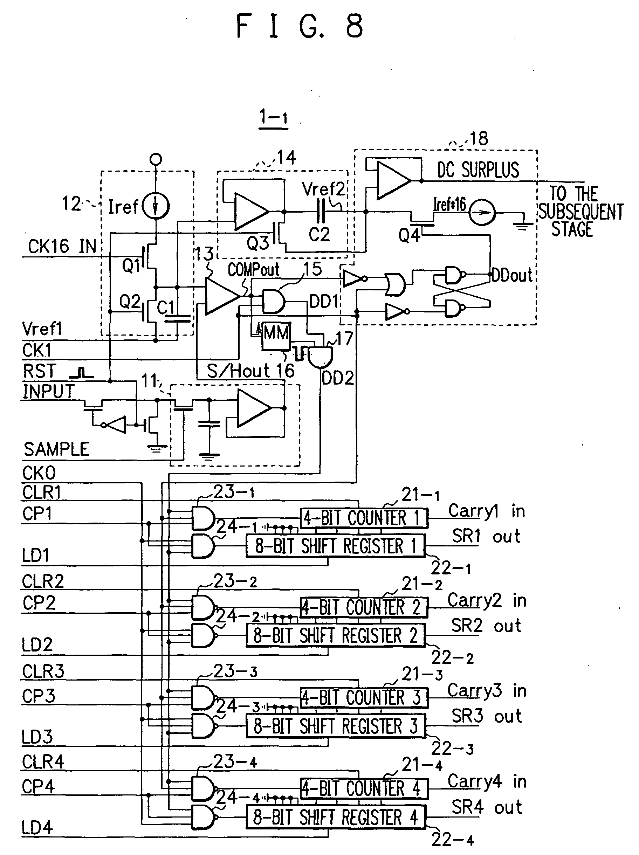

FIG. 8 - FIG. 11 are circuit diagrams showing the combination of the analog processors and digital processors regarding the internal structure of the conversion processor 1₋₁-1₋₄. In such Figures, items that are denoted in the same code as shown in FIG. 4 have the same respective functions. Thus, overlapping explanations are omitted here. Additionally, FIG. 8- FIG. 11 show the almost same structures. Thus, any of them may be used for explanations as a typical example.

For example, when FIG. 8 is explained, the counter 2₋₁ shown in FIG. 3 is structured based on 4 4-bit counters 21₋₁-21₋₄. And the shift register 3₋₁ shown in FIG. 3 is structured based on 4 8-bit shift registers (4 bits from MSB are fixed as 0) 22₋₁-22₋₄. CLR1-CLR4 show the timing-clock to clear the 4-bit counters 21₋₁-21₋₄. And LD1-LD4 show the timing-clock to control the data load, where such control is performed from the 4-bit counters 22₋₁-22₋₄ to the 8-bit shift registers 22₋₁-22₋₄. And the CK0 shows the timing-clock to control the shift operations of the 8-bit shift registers 22₋₁-22₋₄.

A pair of AND gates 23₋₁-23₋₄ performs the AND operation regarding the main clock CK1, the output signal DD2 of the AND gate 17, and control pulses CP1-CP4. The 4-bit counters 22₋₁-22₋₄ count the number of clocks outputted from the AND gates 23₋₁-23₋₄. Another pair of AND gates 24₋₁-24₋₄ performs the AND operation regarding the shift clock CK0, the output signal DD2 of the AND gate 17, and control pulses CP1-CP4. The 8-bit shift registers 22₋₁-22₋₄ synchronize the clock outputted by such AND gates 24₋₁-24₋₄ and execute the shift operations.

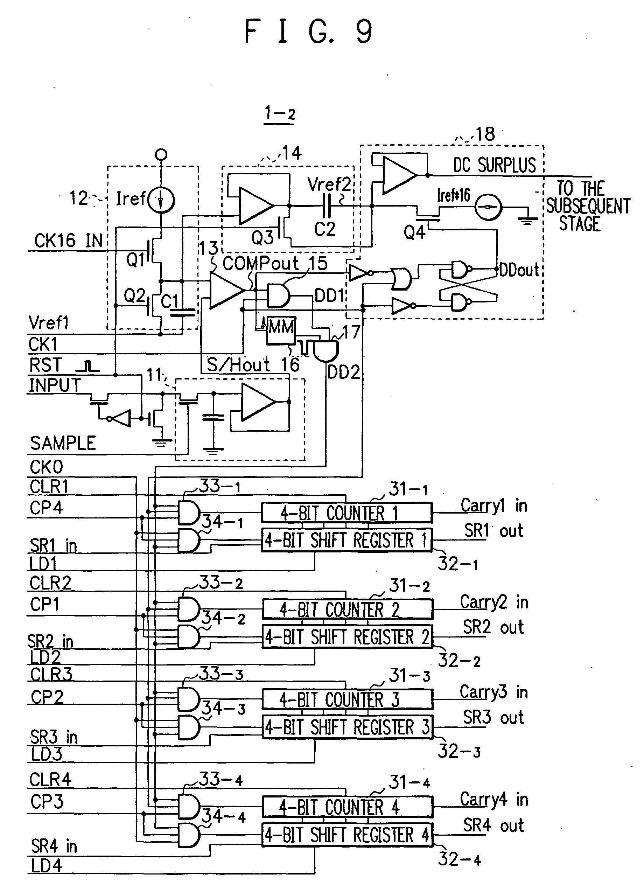

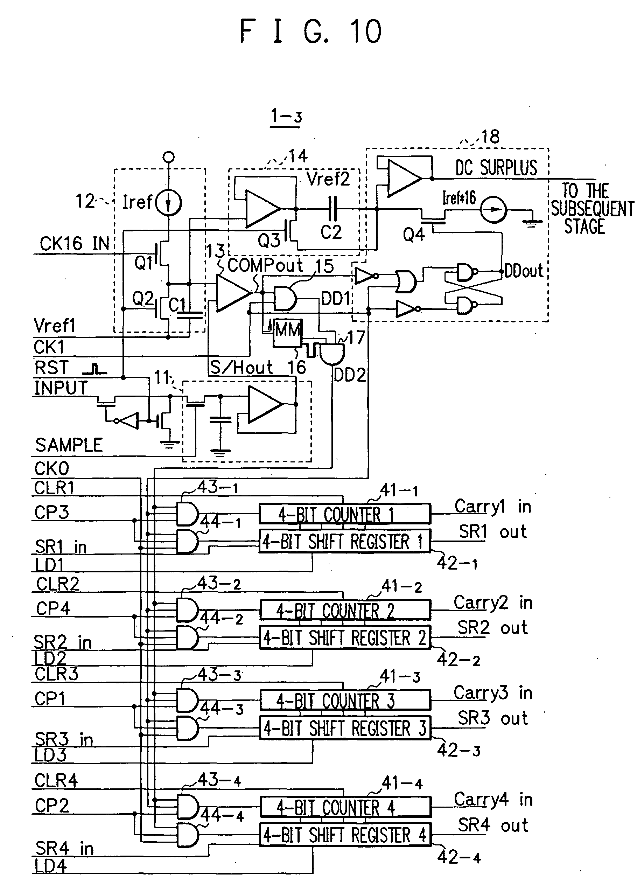

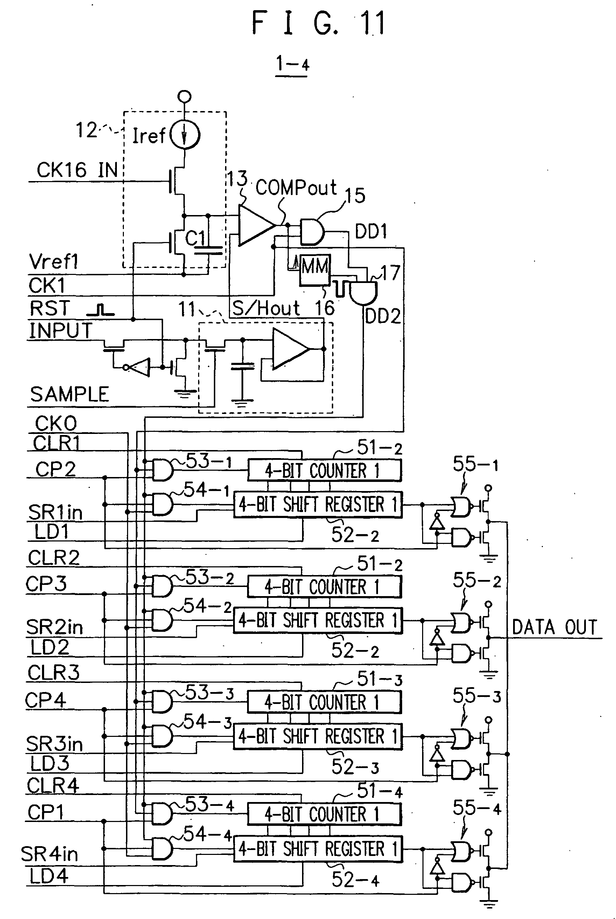

That is to say, the count values held in the 8-bit shift registers 22₋₁-22₋₄ by the load clocks LD1-LD4 (4 bit digital signals) are transmitted to the 4-bit shift registers 32₋₁-32₋₄ (FIG. 9) with which the conversion processor 1₋₂ at the second stage is equipped, according to the application of the shift clock CK0. At this time, the 4-bit digital signals held in the 4-bit shift registers 32₋₁-32₋₄ at the second stage are transmitted to the 4-bit shift registers 42₋₁-42₋₄ (FIG. 10) at the third stage at the same time of applying the shift clock CK0. And the 4-bit digital signals held in the 4-bit shift registers 42₋₁-42₋₄ at the third stage are transmitted to the 4-bit shift registers 52₋₁-52₋₂ (FIG. 11) at the fourth stage.

In the conversion processor 1₋₄ at the final stage, as shown in FIG. 11, the digital signals are outputted via the output buffer circuits 55₋₁-55₋₄ that are connected on the output side of the 4-bit shift resisters 52₋₁-52₋₄. That is to say, all of 16-bit digital signals held in the 20-bit shift register that is structured based on the shift registers 22₋₁-22₋₄, 32₋₁-32₋₄, 42₋₁-42₋₄, and 52₋₁-52₋₄ of each conversion processor 1₋₁-1₋₄ (equivalent to the shift registers 3₋₁-3₋₄ in FIG. 3) are outputted via the output buffer circuits 55₋₁-55₋₄ while the shift clock CK0 is applied . In addition, regarding the conversion processor 1₋₄ at the final stage, it is unnecessary to include a circuit to detect surplus voltage at the analog processor, and no such circuit is established.

As explained the details, according to the embodiment, the conversion processors on the 4-bit unit are connected in a multistage manner, and the 4-bit digital signal is obtained through counting the number of clocks according to the analog input voltage at each conversion processor. Also, the surplus voltage obtained in the conversion processor at the preceding stage is transmitted into the conversion processor at the subsequent stage, and A/D conversion is executed. Thus, 16-bit high resolution can be realized as a whole. Moreover, 4-bit high resolution may be achieved at the individual conversion processors. Thus, it is acceptable not to cause the clock frequency of the counter to be high. This can reduce elements of erroneous causes, such as distortion of wave form for a clock pulse. While achieving the high resolution, A/D conversion accuracy can be improved.

Furthermore, according to the embodiment, the surplus voltage obtained at a certain conversion processor that, is multiplied by 16 (magnification according to the resolution of the conversion processor, and 2⁴ times applies in the example) is transmitted to the conversion processor at the subsequent stage. Thus, it is not necessary to raise the clock frequency so as to enable the number of clocks to be counted using small surplus voltage itself. And it is possible to operate based on the same clock frequency as that of the preceding stage even in the conversion processor at the subsequent stage. Moreover, since magnification by 16 is carried out through DC, S/N is not deteriorated, and the high A/D conversion accuracy can be preserved.

Also, according to the embodiment, the maximum value V_{ref2} of the lamp voltage is used, and the way of detecting the surplus voltage is devised. Through this, the DC surplus obtained at a certain conversion processor can be directly transmitted to the conversion processor at the subsequent stage. It is possible to conceive of a method where the D/A conversion is executed to result in a situation where A/D conversion has been made at the high-order bit conversion processor, where such result is returned to the analog amount, and where the difference between such result and the input analog signal is transmitted to the low-bit conversion processor. However, compared with this, the method of the embodiment can greatly simplify the processes.

Moreover, according to the embodiment as mentioned above, the surplus voltage multiplied by 16 which is obtained at a certain conversion, is transmitted to the conversion processor at the subsequent stage. Thus, even regarding the conversion processor after the second stage, A/D conversion can be performed with completely the same timing as the clock frequency at the first stage. Therefore, it is not necessary to perform integration moderately so as to preserve accuracy. Thus, while maintaining the accuracy of the A/D conversion, increased speed up of conversion can be sufficiently attempted.

Furthermore, according to the embodiment, the digital processors with which the plurality of the conversion processors are equipped are structured in 4 layers. This can cause the A/D conversion to operate in a parallel-serial manner. Thus, the speed of the A/D conversion can be further increased.

Also, regarding the reference voltage V_{ref} required so as to perform integration (generation of lamp voltage), one type thereof may be applied. Thus, the circuit structure for such purpose will not be complicated. Additionally, it is not necessary to establish a D/A conversion apparatus in order to obtain the difference signal mentioned above, or to establish many comparators so as to speed the A/D conversion up. Therefore, the problem of a circuit becoming large in size or having a high cost can be avoided. Furthermore, since the plurality of the conversion processors connected in a multistage manner have the almost same structures, integration into the semiconductor chip is remarkably easy.

Additionally, according to the embodiment above, an explanation where a 16-bit resolution A/D conversion apparatus is structured so as to be divided into 4 conversion processing units based on the 4-bit unit is made. However, the resolution and the number of divisions thereof are simply examples, and the embodiment is not limited thereto.

Also, according to the embodiment above, an example is given where all conversion processors have analog processors and digital processors. Regarding a case that emphasizes the minimization of circuit size, for example, a single analog processor alone may be established, as a whole and may be commonly used by each conversion processor. In such case, the switch circuit may be established at the signal input stage of the analog processor, and the analog signal as a target of A/D conversion and the DC surplus outputted from the analog processor may be inputted to such switch circuit. And switch circuit may select either the signal or the DC surplus (initially, the analog signal is selected, and the DC surplus is chosen thereafter).

Moreover, according to the embodiment above, an example is given where, when the 4-bit count value is obtained at each conversion processor, the negative output mono stable multi-vibrator 16 is used so as to obtain the signal DD2 where one of the numbers of main clock CK1 is reduced. However, the present invention is not limited thereto. For example, the pulse signal CK 15 to which a rising edge is made more slowly by 1 clock of the main clock CK 1 than the pulse signal CK 16, and to which a falling edge is made at the same time as the pulse CK 16, is generated. Such pulse signal CK 15 may be further added to the input of the AND gate 15. In such case, neither negative output mono stable multi-vibrator 16 nor AND gate 17 is necessary, and the output signal of the AND gate 15 becomes DD2 as it is.

Additionally, according to the aforementioned embodiment, using lamp voltage that gradually increases from the reference voltage V_{ref1} (a slightly smaller than minimum value of the analog voltage as a target of A/D conversion), the counting of the number of clocks is performed. On the contrary, it may be acceptable to count the number of clocks by using voltage that gradually decreases from a slightly larger reference voltage than the maximum value of the analog voltage as a target of A/D conversion.

In addition, the embodiments explained above have shown only a single example of the possible incarnations upon implementing the present invention. This should not cause the technical scope of the present invention to be restrictively interpreted. This is to say, the present invention can be implemented in various forms without deviating from the spirit or the main characteristics thereof.

According to the present invention as explained above, without causing circuit size to increase, the improvement of speed and resolution of A/D conversion can be achieved.

### [Industrial Applicability]

The present invention is useful in that without causing a circuit size to become larger, the improvement of speed and resolution of A/D conversion can be achieved.

## Claims

1. An analog-digital conversion apparatus that converts an analog signal into a digital signal based on the predominated bit unit, comprising:
a lamp voltage generation circuit that generates lamp voltage changing at a certain rate from the predominated reference voltage;
a counter circuit that counts the number of complete clocks included during a period until said lamp voltage and analog input voltage are matched, and that outputs a digital signal of the predominated number of bits in proportion to said analog input voltage; and
a surplus detection circuit that detects an incomplete clock other than said complete clock included during a period until said lamp voltage and said analog input voltage are matched, and that outputs voltage in proportion to the time of said incomplete clock as the surplus voltage;
wherein said digital signal of the predominated number of bits is outputted by initially counting the number of said complete clocks included during a period until said lamp voltage and said analog input voltage are matched, and wherein said digital signal of the predominated number of bits is outputted by counting the number of said complete clocks during a period until said lamp voltage and said surplus voltage are matched thereafter.

2. The analog-digital conversion apparatus according to claim 1, wherein said surplus detection circuit outputs surplus voltage that is multiplied several times according to the resolution.

3. The analog-digital conversion apparatus according to claim 2, wherein, based on a performance where the voltage value resulting when the voltage in proportion to the time from when said lamp voltage and said analog input voltage are matched until when the next clock starts multiplied several times according to said resolution is deducted from the maximum value of said lamp voltage, said surplus detection circuit obtains the surplus voltage that is multiplied several times according to said resolution.

4. The analog-digital conversion apparatus according to claim 1, wherein conversion processors that convert an analog signal into a digital signal based on the predominated bit unit are connected at a plurality of stages, each of such conversion processors has said lamp voltage generation circuit, said counter circuit, and said surplus detection circuit, said surplus voltage outputted from a conversion processor at the preceding stage is inputted into a conversion processor at the subsequent stage as said analog input voltage, and said conversion processors at the plurality of stages operate in parallel.

5. An analog-digital conversion apparatus, wherein conversion processors that convert an analog signal into a digital signal on the predominated bit unit are connected at a plurality of stages, the number of clocks according to the analog input voltage is counted at each conversion processor, the digital signal of the predominated bits is obtained, the surplus voltage in proportion to the length of incomplete clock that is not counted at each said conversion processor is obtained and transmitted into a conversion processor at the subsequent stage, said conversion processor at the subsequent stage processes said surplus voltage as said analog input voltage, and the digital signal of the predominated bits obtained at each said conversion processor is outputted as a digital signal of the desirable resolution as a whole.
